(19) Europäisches Patentamt / European Patent Office / Office européen des brevets

(11) **EP 2 919 389 A1**

(12) **EUROPEAN PATENT APPLICATION**

(43) Date of publication:
16.09.2015 Bulletin 2015/38

(51) Int Cl.:
*H03M 7/30* (2006.01)

(21) Application number: 14158889.7

(22) Date of filing: 11.03.2014

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventors:
• **Naef, Martin**
  **5443 Niederrohrdorf (CH)**
• **Larsson, Mats**
  **5405 Baden-Dättwil (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(54) **Storage of power system measurement data**

(57) The present invention is concerned with a cost effective historian system that supports long term access to power system data originating from Phasor Measurement Units. According to the invention, a method of storing a plurality of blocks of power system data samples comprises the steps of performing a wavelet transform for each block of data samples to generate wavelet coefficients of a plurality of levels-of-detail, or wavelet generations, and storing, in a historian of the power system, the wavelet coefficients from different blocks and pertaining to a same level-of-detail as one stream of wavelet coefficients.

Fig. 2

EP 2 919 389 A1

**Description**

FIELD OF THE INVENTION

The invention relates to the field of electrical power transmission and distribution systems, specifically to the long-term storage of large amounts of power system state data for the purpose of statistical analysis.

BACKGROUND OF THE INVENTION

Wide Area Monitoring of electrical power transmission systems by means of distributed Phasor Measurement Units (PMU) produces a large stream of power system data. A single PMU data stream for a feeder or bus typically includes up to six complex values (amplitude and phase angle for both voltage and current, for three phases) plus frequency, which are all updated up to 60 times per second. If stored with binary, single precision floating point data and no extra overhead, such a stream amounts to 3360 bytes per second, ca. 290MB per day or 106GB per year of raw data for a single PMU.

Storing such vast amounts of power system data poses significant challenges even for modest deployments with tens of PMUs, while for larger installations huge data centers would be required. For reasons of data storage limitation and unless efficient data reduction techniques are applied, utilities thus only store PMU data for a limited duration of e.g. a few months in a real-time database. This precludes a later analysis for statistical purposes and/or for optimized forecasting. Querying vast amounts of historical PMU data poses a performance problem, especially where only partial or subsampled data is required.

The paper by Ning, J, Wang, J et al., entitled "A Wavelet-Based Data Compression Technique for Smart Grid", IEEE Transactions on Smart Grid, vol 2., no.1, 2011, presents the uses of the wavelet transform, or wavelet decomposition, for compression of (simulated) PMU data. The compression is not lossless, but compression up to a factor of 5 can be done with minimal loss of information. The paper also demonstrates the efficiency of the wavelet transform to reduce noise in the PMU measurements.

The principles and methods of the following invention are by no means restricted to a use in electrical power systems, but likewise applicable to other utility process control systems, or Supervisory Control And Data Acquisition SCADA systems, producing equisampled measurement data e.g. for monitoring of distributed transmission and distribution systems such as pipelines for fluids such as water, oil, or gas.

DESCRIPTION OF THE INVENTION

It is therefore an objective of the invention to support long term access to power system data comprising blocks of power system data samples with fixed sampling rate, and specifically originating from distributed Phasor Measurement Units PMUs of the power system. This objective is achieved by a method and a device according to the independent claims. Preferred embodiments are evident from the dependent patent claims.

According to the invention, a method of storing, or handling, a plurality of blocks, or sequences, of power system data samples, or data values, comprises the steps of:

  for each block of data samples, performing a wavelet transform of the data samples to generate wavelet coefficients of, or pertaining to, a plurality of levels-of-detail, or wavelet generations, and

  storing, instead of the data samples of the block, in a historian, or data archive, of the power system, the wavelet coefficients from different blocks and pertaining to a same level-of-detail as one stream of wavelet coefficients, specifically as an identifiable, locatable sequence of wavelet coefficients in a level-specific file.

In a preferred variant of the invention, the method includes deleting from the historian, at any later time, a stream of wavelet coefficients, specifically of the largest stream corresponding to the highest level-of-detail, thereby reducing memory space required at the expense of fidelity or precision.

In an advantageous embodiment of the invention, the data samples of a block include time-wise dispersed sequential data values of a Phasor Measurement Unit of the power system measured over a period of time, or a collection of geographically dispersed synchronous data values from a plurality of PMUs distributed over a region, or part, of the power system area.

The present invention proposes a solution for long-term storage of high-frequency measurements of the power system state, specifically for phasor measurement data. The proposed system offers the following advantages:

-    Efficient storage of data series with no overhead in terms of disk capacity and only a modest overhead in terms of processing time during the recording operation;

-    Extremely efficient retrieval of lower-resolution time series and resampling;

-    The option to progressively reduce the resolution of old data without computational overhead in order to save storage space while retaining as much historical data as possible;

-    The option to retain high resolution data for selected events; and

- A resulting data structure that immediately supports signal processing such as de-noising or compression by way of algorithms that require a local analysis in the frequency domain.

The present invention also relates to a computer program product including computer program code for controlling one or more processors of a device adapted to receive, process and store power system data, particularly, a computer program product including a computer readable medium containing therein the computer program code.

BRIEF DESCRIPTION OF THE DRAWINGS

The subject matter of the invention will be explained in more detail in the following text with reference to preferred exemplary embodiments which are illustrated in the attached drawings, in which:

Fig.1  depicts two Haar wavelets;
Fig.2  depicts a Haar wavelet decomposition scheme;
Fig.3  depicts an overview of the proposed storage scheme; and
Fig.4  depicts an adaptive level-of-detail for a region of interest.

DETAILED DESCRIPTION OF PREFERRED EMBODIMENTS

Each individual PMU data stream is subdivided into blocks (e.g. one block per day) consisting of N samples. Each block is decomposed into $\log2(N)$ levels of detail using the wavelet decomposition, or wavelet transform. The base or parent wavelet function is chosen according to the application needs. A simple and highly computationally efficient base wavelet is the Haar wavelet. Other base functions may be used to support efficient resampling without aliasing artifacts, wherein the computational complexity for wavelet decomposition depends on the complexity of the wavelet base function. In most cases, the necessary filtering can be implemented as FIR filtering with small kernels. Decomposition can easily be parallelized for multi-core architectures. Decomposition can run continuously on the incoming data and with bounded complexity. There is no requirement to keep the complete block in memory, it is sufficient to store the current branch of the tree.

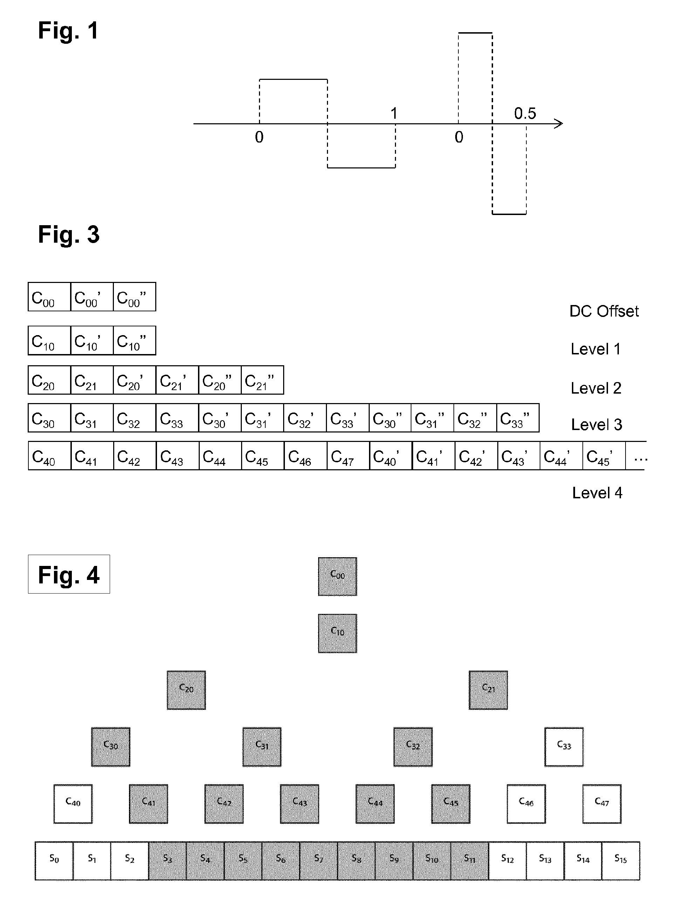

Fig.1 depicts a Haar base wavelet $\psi_{0,0}$ (left) and a first level, or first order, Haar child wavelet $\psi_{l,k}$ (right). Subject to appropriate normalization, general level n wavelets located around position k (designated $\psi_{n,k}$) may be defined as

$$\psi_{n,k}(t) = 2^{n/2}\,\psi_{0,0}\,(2^n t - k)$$

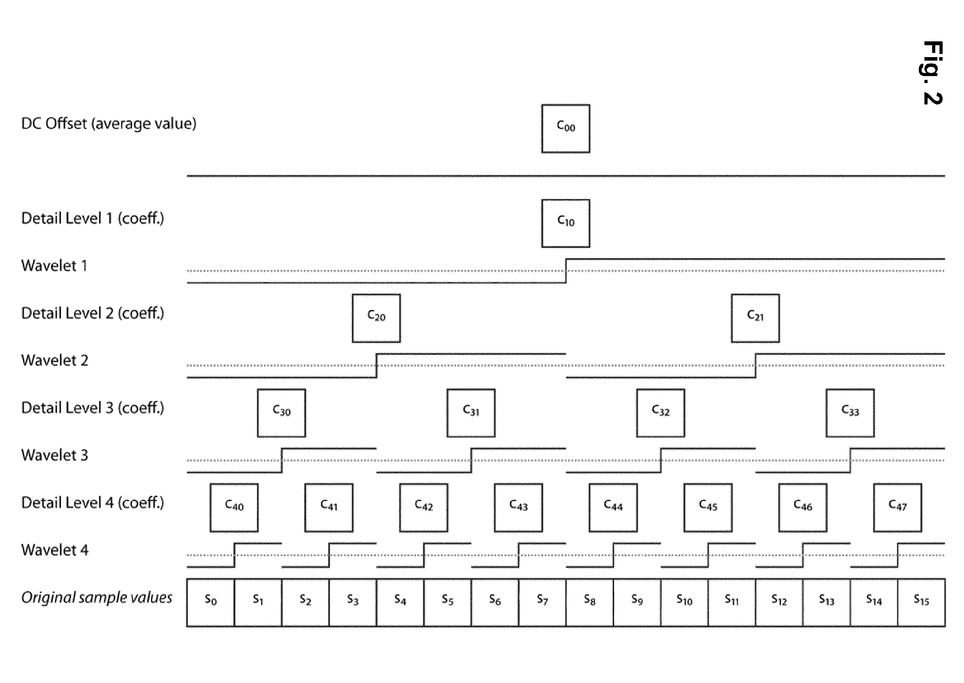

Fig.2 depicts a Haar wavelet decomposition scheme for 16 samples $s_0$ to $s_{15}$ of PMU data with four levels-of-detail superposing a constant, or Direct Current DC, component as known from Fourier transform. The wavelet coefficient $c_{nk}$ for subset k of level n is based on the difference between the mean data values of two next level data subsets making up subset k, specifically proportional to the variance of the data values in subset k. A corresponding reconstruction example at maximum level of detail equivalent to a lossless restoration of the original signal is then obtained by calculating

$$S_{10} = C_{00} + C_{10} - C_{21} + C_{32} - C_{45}$$

$$S_{11} = C_{00} + C_{10} - C_{21} + C_{32} + C_{45}$$

Fig.3 depicts an overview of the proposed storage scheme, for three consecutive blocks of input data with 48 input samples and 48 coefficients. Each level of the wavelet decomposition is stored as a separate stream, i.e. as a separate file, by the proposed storage system. The total amount of stored data remains the same as in the original linear data stream. Special coding schemes may be applied to support compression.

The original data stream can be reconstructed efficiently and without losses from the original data set if all the levels of detail are retrieved. However, a lower resolution data stream can be reconstructed by only considering L ($<=\log2(N)$) levels of detail. The exact properties of the lower resolution stream depend on the base function. In the case of a Haar wavelet, each coefficient stored represents a difference such that the two intermediate values that may be reconstructed based on the hierarchy represent two average values within the time span, or support, of the wavelet. A reconstruction of reduced resolution with L=2 levels-of-detail, equivalent to one quarter of the original resolution, or an average over four consecutive samples, is obtained by calculating:

$$\text{average }(S_0 \text{ to } S_3) = C_{00} - C_{10} - C_{20}$$

$$\text{average }(S_8 \text{ to } S_{11}) = C_{00} + C_{10} - C_{21}$$

The proposed storage scheme enables fast retrieval of the sample streams at any specified resolution. A suitable base function ensures that the subsampled data stream is already filtered according to the application needs. This massively reduces the processing time for queries where only a coarse resolution dataset is required compared to the traditional approach that requires a full filtering on the fly at query time. Accordingly, retrieval may be done very efficiently for specific applications where just a desired level-of-detail is required, for example for a trend display or forecasting applications, the latter requiring a time resolution heavily dependent on the forecast period. The lower overhead also enables SCADA and/or real-time applications to use data from a dedicated historian database operating in parallel to a real-time database.

The choice of the base function allows to balance computational load against the quality of resampling. Reconstruction times for the full resolution dataset will be similar to decomposition. While wavelet decomposition requires the same amount of storage space as the traditional linear approach, disk data transfer rates however are massively reduced when querying the data set at lower resolution due to the pre-computed levels of detail. Progressive streaming of data is thus inherently supported by the data structure. For queries where the system response time may be slow (e.g. because the data needs to be restored from a secondary medium such as a tape library, or because the communication link might have limited bandwidth), it may be beneficial to present a low resolution preview to the operator that is progressively refined.

The level of detail scheme supports optimization of the storage capacity. Current solutions simply overwrite old data once the allocated storage capacity is exhausted. Afterwards, there is no possibility to review historic data (e.g. to optimize forecasting). The proposed scheme however allows the simple deletion of selected levels of detail without the need to touch the remaining data. It is therefore possible to progressively reduce the fidelity of historical data depending on age with trivial overhead. Rather than simply extracting the full resolution data, resampling it and storing in a new smaller database file, one could simply delete the data corresponding to the higher level of detail. This efficient reduction scheme avoids performance bottlenecks in the historian database, which therefore does not need to be disconnected from the live system for heavy maintenance operations.

Wavelet coding supports variability in the level of detail even within the full block due to the finite support of the base function (contrary to e.g. Fourier transform). In practice, this means that certain regions could be marked as important (e.g. before and after a disturbance) and therefore exempted from the automatic level of detail reduction scheme for historical data. In some cases this storage scheme might introduce a small overhead (e.g. where regions are badly aligned to block boundaries), but only if the level of detail has been reduced strongly.

Fig.4 depicts an adaptive level-of-detail for a region of interest $s_3$ to $s_{11}$ comprised in a block of 16 samples $s_0$ to $s_{15}$. In this example, if levels 0, 1, 2 are retained in storage following a global data reduction, the 8 extra coefficients on levels 3 and 4 (shaded; $c_{30}$ to $c_{32}$ and $c_{41}$ to $c_{45}$) must be kept to restore the full region of interest comprising 9 samples. This is equivalent to an economy of one data entry.

While the invention has been described in detail in the drawings and foregoing description, such description is to be considered illustrative or exemplary and not restrictive. Variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. The mere fact that certain elements or steps are recited in distinct claims does not indicate that a combination of these elements or steps cannot be used to advantage, specifically, in addition to the actual claim dependency, any further meaningful claim combination shall be considered disclosed.

**Claims**

1. A method of storing blocks of power system data samples, comprising

    - for each block of data samples ($s_0$ ... $s_{15}$), performing a wavelet transform of the data samples to generate wavelet coefficients ($c_{00}$ ... $c_{47}$) of a plurality of levels-of-detail,
    - storing, in a historian of the power system, the wavelet coefficients from different blocks ($c_{20}$, $c_{21}$; $c_{20}'$, $c_{21}'$; $c_{20}''$, $c_{21}''$) and pertaining to a same level-of-detail as one stream of wavelet coefficients.

2. The method of claim 1, comprising

    - deleting from the historian a stream of wavelet coefficients ($c_{40}$ ... $c_{47}$).

3. The method of claim 1, comprising

    - deleting from the historian a stream of wavelet coefficients ($c_{40}$ ... $c_{47}$) while retaining a subset of wavelet coefficients ($c_{41}$ ... $c_{45}$) of the stream enabling reconstruction of the original data samples in a region of interest.

4. The method of claim 1, wherein the wavelet transform comprises

    - for each level-of-detail (n), assign each data value to one subset (k) of data values,
    - for each level-of-detail and for each subset, calculate a wavelet coefficient $c_{nk}$.

5. The method of claim 4, wherein the wavelet transform is based on Haar wavelets, and wherein the wavelet coefficient $c_{nk}$ for subset k of level n is proportional to the variance of the data samples in subset k.

6. The method of one of claims 1 to 5, wherein the data samples of a block include data values of a Phasor Measurement Unit, PMU, of the power system, or a collection of synchronous data values from a plurality of PMUs.

7. A system for storing blocks of power system data samples, comprising a historian database and data processing equipment configured to receive, process and handle power system data according to one of claims 1 to 5.

## Fig. 1

## Fig. 3

| $C_{00}$ | $C_{00}'$ | $C_{00}''$ | | | | | | | | | | | | DC Offset |

| $C_{10}$ | $C_{10}'$ | $C_{10}''$ | | | | | | | | | | | | Level 1 |

| $C_{20}$ | $C_{21}$ | $C_{20}'$ | $C_{21}'$ | $C_{20}''$ | $C_{21}''$ | | | | | | | | | Level 2 |

| $C_{30}$ | $C_{31}$ | $C_{32}$ | $C_{33}$ | $C_{30}'$ | $C_{31}'$ | $C_{32}'$ | $C_{33}'$ | $C_{30}''$ | $C_{31}''$ | $C_{32}''$ | $C_{33}''$ | Level 3 |

| $C_{40}$ | $C_{41}$ | $C_{42}$ | $C_{43}$ | $C_{44}$ | $C_{45}$ | $C_{46}$ | $C_{47}$ | $C_{40}'$ | $C_{41}'$ | $C_{42}'$ | $C_{43}'$ | $C_{44}'$ | $C_{45}'$ | ... |

Level 4

## Fig. 4

Fig. 2

EP 2 919 389 A1

Fig. 2

Europäisches
Patentamt

European
Patent Office

Office européen
des brevets

# EUROPEAN SEARCH REPORT

**Application Number**

EP 14 15 8889

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SANTOSO S ET AL: "Power Quality Disturbance Data Compression using Wavelet Transform Methods", IEEE TRANSACTIONS ON POWER DELIVERY, vol. 12, no. 3, 1 July 1997 (1997-07-01), pages 1250-1257, XP011089019, ISSN: 0885-8977, DOI: 10.1109/61.637001 * the whole document * | 1-7 | INV. H03M7/30 |
| X | HSIEH C-T ET AL: "Disturbance data compression of a power system using the Huffman coding approach with wavelet transform enhancement", IEE PROCEEDINGS: GENERATION, TRANSMISSION AND DISTRIBUTION, vol. 150, no. 1, 15 January 2003 (2003-01-15), pages 7-14, XP006019625, ISSN: 1350-2360, DOI: 10.1049/IP-GTD:20030071 * the whole document * | 1-7 | |
| | ----- | | **TECHNICAL FIELDS SEARCHED (IPC)** |
| A | MALLAT S G: "A theory for multiresolution signal decomposition: The wavelet representation", IEEE TRANSACTIONS ON PATTERN ANALYSIS AND MACHINE INTELLIGENCE, IEEE COMPUTER SOCIETY, vol. 11, no. 7, 1 July 1989 (1989-07-01), pages 674-693, XP002363435, ISSN: 0162-8828, DOI: 10.1109/34.192463 * the whole document * | 1-7 | H03M |
| | ----- | | |
| | -/-- | | |

The present search report has been drawn up for all claims

| Place of search | Date of completion of the search | Examiner |
|---|---|---|
| The Hague | 11 July 2014 | André, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 14 15 8889

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DESHPANDE S ET AL: "HTTP streaming of JPEG2000 images", PROCEEDINGS INTERNATIONAL CONFERENCE ON INFORMATION TECHNOLOGY, 2 April 2001 (2001-04-02), pages 15-19, XP002193324, * abstract * * sections 3 and 4 * | 1-7 | |
| A | TCHEOU MICHEL P ET AL: "The Compression of Electric Signal Waveforms for Smart Grids: State of the Art and Future Trends", IEEE TRANSACTIONS ON SMART GRID, vol. 5, no. 1, 1 January 2014 (2014-01-01), pages 291-302, XP011536214, ISSN: 1949-3053, DOI: 10.1109/TSG.2013.2293957 [retrieved on 2013-12-24] * abstract * * sections I, III.A - III.C * | 1-7 | |

TECHNICAL FIELDS
SEARCHED (IPC)

The present search report has been drawn up for all claims

| Place of search | Date of completion of the search | Examiner |
|---|---|---|
| The Hague | 11 July 2014 | André, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **NING, J ; WANG, J et al.** A Wavelet-Based Data Compression Technique for Smart Grid. *IEEE Transactions on Smart Grid,* 2011, vol. 2 (1